# EUROPEAN PATENT APPLICATION

(11) **EP 4 588 602 A1**
(43) Date of publication of application: **23.07.2025**
(21) Application number: 24153094.8
(22) Date of filing: 22.01.2024
(51) Int. Cl.: B23K 20/00, B23K 26/08, B23K 26/36, B23K 26/362

(54) **METHOD AND APPARATUS FOR MACHINING A BLANK, AND WIRE BONDING CAPILLARY**

(71) Applicant: SPT Roth AG, 3250 Lyss (CH)
(72) Inventor: KÖHLER, Harald, 3250 Lyss (CH); WITTE, Reiner, 3250 Lyss (CH); KEHL, Anton, 3250 Lyss (CH)
(74) Representative: Frei Patent Attorneys

(57) **Abstract**

A method for machining a blank comprises the steps of
• providing a blank made of a sintered ceramic material;
• laser machining the blank with a laser beam (22) oriented to impinge tangentially on the surface of the blank,
• while continuously rotating the blank (1) around an axis of rotation, corresponding to a longitudinal axis of the blank (1),
• thereby machining at least two surface sections of the blank,
o the at least two surface sections being rotationally symmetric with regard to the longitudinal axis (19), and
o the at least two surface sections being separated by a boundary curve, where a curve on the surface crossing the boundary curve has a stepwise change in curvature, and a smooth change in the direction of a surface normal,
o in particular wherein the boundary curve lies in a plane that is normal to the longitudinal axis (19).

## Description

The invention relates to wire bonding capillaries, and in particular to a method and apparatus for machining a blank and to a wire bonding capillary as described in the preamble of the corresponding independent claims.

Wire bonding capillaries - to be referred to simply as capillaries from now on - and their use in a wire bonding process are described, for example, in US 6'311'890 B1. It is further known to manufacture capillaries from sintered ceramic materials and to create small-scale structures on part of a front facing working surface. Such small-scale structures are shown in CN 108389806, CN 109860067, CN 110842339, CN 113764295 and CN 113927187 and can be manufactured by laser ablation or sublimation. The basic shape of the capillaries and in particular their tips is formed by grinding and polishing.

It is an object of the invention to create a method and apparatus for machining a blank of the type mentioned initially, in particular for creating a wire bonding capillary, which allow for a more rapid machining process than existing methods and apparatuses. A further object is to provide a wire bonding capillary manufactured in this manner.

These objects are achieved by a method and apparatus for machining a blank and to a wire bonding capillary according to the corresponding independent claims.

The method for machining a blank comprises the steps of:
- providing a blank made of a sintered ceramic material;
- laser machining the blank with a laser beam oriented to impinge tangentially on the surface of the blank,
- while rotating the blank around an axis of rotation, the axis of rotation coinciding with or being parallel to a longitudinal axis of the blank,
- thereby machining at least two surface sections of the blank,
   ∘ the at least two surface sections being rotationally symmetric with regard to the longitudinal axis, and
   ∘ the at least two surface sections being separated by a boundary curve, where a curve on the surface crossing the boundary curve has a stepwise change in curvature, and a smooth change in the direction of a surface normal,
   o in particular wherein the boundary curve lies in a plane that is normal to the longitudinal axis.

In embodiments, the blank is rotated continuously. The laser beam impinging tangentially on the surface of the blank means that, at or near the focus point or waist of the laser beam, a part of the laser beam does not impinge on the blank, and a complementary part of the laser beam does impinge on the blank. So, only a part of the energy of the beam hits the material of the blank.

Commonly, when laser machining sintered ceramic materials, the laser beam is oriented generally at a right angle to the surface being machined, that is, generally parallel to a surface normal of the surface. This results in grains of the sintered structure to absorb the entire energy of a laser pulse and to evaporate or sublimate as a whole. This in turn results in a relatively rough overall structure of the material surface: The roughness is determined by the grain size of the sintered material. If the laser beam is oriented tangentially to the surface, not the entire energy of a pulse is absorbed by a particular grain, and the grain will only evaporate or sublimate in part. As a result, when seen over multiple grains, the surface of the material is structured more finely than when entire grains are evaporated or sublimated.

It is understood that when specifying the angle of the laser beam relative to the surface, the direction of the surface is not necessarily that of a local surface patch - which is being machined and modified by the laser beam - but an average, global direction of the surface. This can also be called the average surface or the reference surface in the section of the surface of the blank being machined.

For example, when small-scale structures are being machined in the working surface or face surface of a **capillary,** then the angle of the laser beam is taken relative to a surface defined by the face angle FA. Likewise, when machining the outer radius surface, the angle of the laser beam is taken relative to a surface defined by the outer radius OR. Typically, the surface of the blank prior to machining is similar (in the geometrical sense) to, or even congruent with the average or reference surface.

In particular, when a direction is said to be tangential to a periphery or circumference of a blank or a capillary, this means that it is essentially tangential to a circle that lies in a plane normal to the blank or the capillary's longitudinal axis, with the radius of the circle being the average radius of the outer surface of the blank or the capillary.

The second-order behaviour of a space curve is described, as is commonly known, by its tangent, curvature and normal vector.

In embodiments, the method comprises machining at least one surface of the blank with the laser beam oriented to fully impinge on the surface, in particular with an angle of more than 20° or more than 40° or more than 60° or more than 80° relative to the surface. So, the entire laser beam can hit the surface.

In particular the at least one surface is a surface that was previously machined with the laser beam oriented tangentially to the surface.

This allows to machine the surface to form small-scale structures in the surface. While doing so, the blank need not be continuously rotated. For a blank for a capillary this can be the case for small-structures in the face surface and/or the inner chamfer surface. Such small-structures can, for example, shape the form of a bonding wire bonded with the capillary. For a particular surface section, the reference shape can be machined tangentially, while rotating the blank, and the small-scale structures by the fully impinging laser beam.

In embodiments, when machining small-structures in a surface the angle of the laser beam relative to the surface can be adjusted by tilting the longitudinal axis of the blank relative to the direction of the laser beam. Typically, it is tilted so that the surface being machined is at least approximately normal to the laser beam. The relative tilting can be accomplished by moving, relative to the environment, either the blank, or the laser beam, or both.

For machining small-scale structures on the face surface, the longitudinal axis can be at least approximately parallel to the laser beam. For a blank being machined to be a capillary, the longitudinal axis can be at an angle at least approximately equal to the face angle FA. In both cases, displacement of the laser beam in directions orthogonal to its direction and relative to the blank can be effected by controlling the direction of the laser beam. Such displacement, but with less speed, is also possible by moving the blank in these directions.

In embodiments, the blank or has a rotationally symmetric shape, with regard to rotation around a longitudinal axis of the blank, in particular with circular symmetry or with n-fold rotational symmetry with n being an integer number larger than one.

This makes it possible to machine such blanks by rotating them about the longitudinal axis. In embodiments, the blank is held in an actuated fixture in which it is rotated relative to the laser beam.

In embodiments, the method comprises machining two or three or four or all surfaces of the blank without interruption, in particular with one or more of the following being the case
- continuously operating the laser to generate a sequence of laser pulses between the machining of adjacent surfaces;
- holding the blank in the same position in an end effector of the actuated fixture.;

This makes it possible to machine one or more surface sections in a continuous machining operation, that is, with a smooth transition of the machining operation from one surface section to the adjacent one.

In embodiments, continuous operation of the laser includes pulsed operation of the laser and/or changes of parameters of the laser's operation during operation.

In embodiments, holding the blank in the same position in the end effector of the actuated fixture includes moving the end effector with the blank, with the relative position of the end effector and the blank remaining unchanged. The end effector, and thus also the blank, can be moved with at least two degrees of freedom. Two such degrees of freedom can be: a rotation around the longitudinal axis of the blank, and a tilting of the longitudinal axis of the blank.

In embodiments, the blank is for a wire bonding capillary. Typically, it can have an outer radius of less than three, in particular less than two millimetres.

This makes it possible to machine a capillary, in particular by machining sections of external surfaces in the region of the tip of the capillary in a single process step. Such sections include one or more of the taper, outer radius surface, face surface and inner chamfer surface. The taper can have a bottleneck shape or a stepped shape, and corresponding subsections of the surface corresponding to the taper. The single process step can comprise holding and rotating the capillary blank, and moving the laser beam and the rotating capillary blank relative to one another, thereby machining these regions one after the other in one continuous process.

The abovementioned at least two surface sections being separated by a boundary curve can be a taper and an outer radius surface of the capillary. So, a smooth transition is generated at the boundary curve between the two. In particular, seen in a sectional plane comprising the capillary axis, the surface of the capillary at the taper runs tangentially into the outer radius surface.

In embodiments, the method comprises continuously rotating the blank 1 with a speed of rotation around the axis of rotation of more than 200 RPM or more than 800 RPM or more than 1'000 RPM or more than 4'000 RPM or more than 10'000 RPM.

This speed of rotation makes it possible to machine the entire blank or capillary in a relatively short time.

In embodiments, the laser pulses have a length between 100 and 1000 femtoseconds, in particular between 200 and 800 femtoseconds, more in particular between 200 and 500 femtoseconds.

In embodiments, the laser pulses have a repetition frequency between 10 kHz and 800 Mhz, in particular between 10 kHz and 10 MHz, more in particular between 50 kHz and 1 MHz

This makes it possible to maintain a level of power that allows for a rapid and precise machining of the material.

The short laser pulses allow for a high pulse frequency. The energy of each pulse, and thereby the average laser power, can be made relatively high. In consequence, even if part of the laser, if it is directed tangentially to the workpiece, does not hit the workpiece, the energy of the part that does hit a grain of the sintered workpiece suffices to evaporate or sublimate a part of the grain.

The high pulse frequency allows for a spatial overlap of successive pulses on the material being machined, as it rotates under the laser bean. The spatial overlap leads to a lower roughness and higher precision of the surface being machined.

In embodiments, the laser pulses have a wavelength between 500 and 550 nanometres, in particular between 515 and 532 nanometres.

With corresponding laser sources operating in the green part of the spectrum (roughly between 495-570 nanometres, more narrowly between 500 and 550 nanometres), as opposed to laser sources with longer wavelengths, the absorption near the surface of the material being machined is better. This leads to a more reliable ablation or sublimation process. This in turn leads to less cracking and less chipping of the material being machined. Also, the beam waist can be made smaller and therefore smaller features can be machined.

In embodiments, the sequence of laser pulses has a fluence between 5 and 20 J/cm², in particular with the wavelength of the pulses being between 515 and 532 nanometres.

This allows to overcome the ablation threshold, in particular for the materials envisioned in the present context.

In embodiments, the main material of the blank is sintered Alumina, or sintered Zirconia or a sintered mixture of Alumina and Zirconia. In particular at least of one of the following is the case
- the sintered material (be it one of the materials named above or another sintered material) has a density of at least 96%,
- the material has a hardness of at least 1200 HV1 (HV stands for the Vickers Hardness or Vickers Pyramid Number).

These material properties are particularly suited for capillaries.

In embodiments, the material of the blank has a grain size of less than three micrometres, in particular less than 2 micrometres.

In embodiments, the method comprises the step of machining a blank for a capillary by the steps of
- orienting the longitudinal axis of the blank to be generally at a **right angle** to the direction of the laser beam and machining an outer periphery of the blank with the laser beam impinging tangentially on the outer periphery of the blank,
   o in particular wherein the outer periphery comprises one or more of a taper, an outer radius surface and a face surface;
- orienting the longitudinal axis of the blank to be generally **parallel** to the direction of the laser beam and machining one or more faces of the blank with the laser beam fully impinging of these faces,
   o in particular wherein these faces are one or more of a face surface and an inner chamfer surface.

This makes it possible to machine the entire outer surface of a capillary in a single continuous process.

The longitudinal axis of the blank being generally at a right angle to the direction of the laser beam means that an angle between the two is larger than 45°, in particular larger than 60°, more in particular larger than 80°.

The longitudinal axis of the blank being generally parallel to the direction of the laser beam means that an angle between the two is smaller than 45°, in particular smaller than 30°, more in particular smaller than 10°.

The direction of the laser beam and the axis of the capillary, unless they intersect, constitute two skew lines. The angle between two skew lines is the angle between one of them and a straight line drawn parallel to the other through a point on the first line.

In embodiments, the method comprises the further step of machining a blank for a capillary by orienting the longitudinal axis of the blank to be **parallel** to the direction of the laser beam and machining at least one of the inner chamfer surface and a hole surface of the blank with the laser beam impinging tangentially on the hole surface.

This makes it possible to machine also a crucial part of the inner surface of the capillary in an extension of same continuous process.

In embodiments, the method comprises the step of machining a blank for a capillary by orienting the longitudinal axis of the blank so that it at least approximately intersects with the laser beam and so that the laser beam is **tangential** to the surface of the outer radius surface or the face surface.

This makes it possible to machine these surfaces from another angle.

In embodiments, the method comprises, in order to align outer surfaces of the blank with an existing hole or wire feed aperture present in the blank, the steps of
- measuring a deviation of the hole with respect to the axis of rotation;
- when machining the blank, compensating for the deviation by deflecting the laser beam depending on an angular position of the blank.

The compensating deflection in particular is effected in a direction normal to the axis of rotation and normal to the direction of the laser beam.

This allows to machine the outer surface of the blank to be concentric with the hole. The center of the hole generally lies on the longitudinal axis of the blank or capillary. The outer surface machined in this typically comprises one or more of the taper, outer radius surface, face surface and inner chamfer surface.

The apparatus for machining a blank comprises
- a laser source for generating a laser beam for machining a blank, the laser source being configured to deflect the laser beam in directions orthogonal to the direction of the laser beam;
- a fixture for holding and rotating the blank 1 around an axis of rotation, the axis of rotation coinciding with or being parallel to a longitudinal axis 19 of the blank 1;
- the laser source and fixture being arranged to be moveable relative to one another to set an angle between the axis of rotation and the laser beam,
   ∘ in particular between a relative position in which they are generally normal and a relative position in which they are generally parallel.

This makes it possible to machine all relevant surfaces of a capillary in a single apparatus, including small-scale surface structures.

The **wire bonding capillary** is manufactured by the method described herein. It can comprise a smooth transition at a boundary curve between two sections at which, seen in a sectional plane comprising the longitudinal axis of the capillary, the surface of the capillary runs tangentially from one of the two sections into the other. One or more of the following can be the case: the taper and outer radius surface run tangentially into one another, the outer radius surface and face surface run tangentially into one another, and the face surface and inner chamfer surface run tangentially into one another.

In embodiments, for at least one surface section, the overall shape of the surface is created by laser machining by a tangentially impinging bean, and small-scale structures on the surface are created by a fully impinging beam.

Further embodiments are evident from the dependent patent claims. Features of the method claims may be combined with features of the device claims and vice versa.

The subject matter of the invention will be explained in more detail in the following text with reference to exemplary embodiments which are illustrated in the attached drawings, which schematically show:
- Figure 1: cross sections of bonding capillaries with different tip types;
- Figure 2: parameters of a tip region of a capillary;
- Figure 3: a bottleneck capillary tip:
- Figure 4: a stepped capillary tip;
- Figure 5-6: a tangentially impinging laser beam;
- Figure 7: a laser beam fully impinging on a surface;
- Figure 8: a laser beam tangentially impinging on a surface;
- Figure 9: a laser beam tangentially impinging on a taper of a capillary;
- Figure 10: a laser beam fully impinging on a face surface of a capillary;
- Figure 11: an apparatus for machining a blank.

In principle, identical or functionally identical parts are provided with the same reference symbols in the figures.

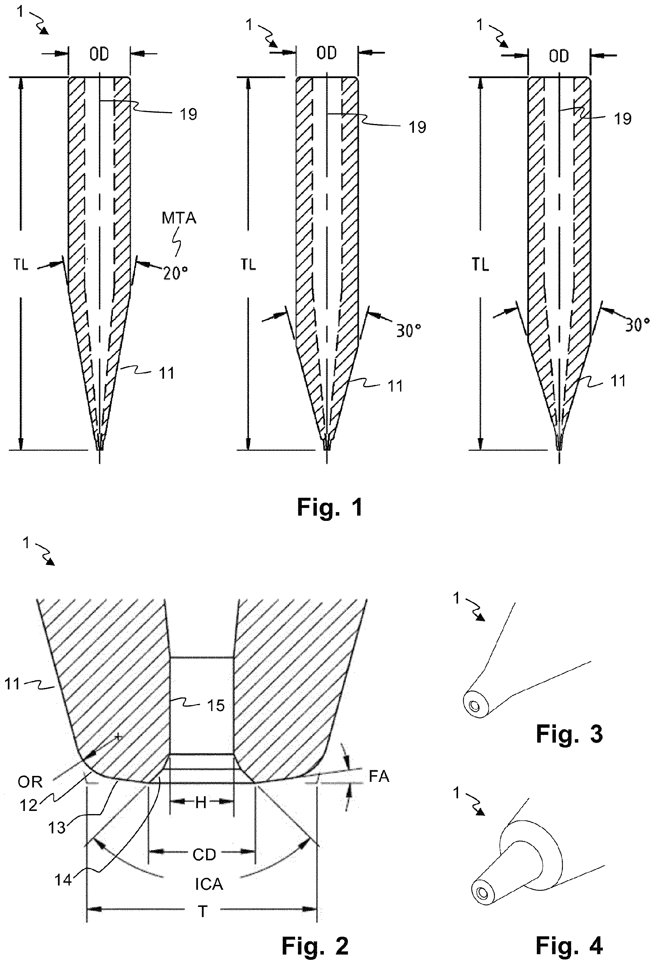

**Figures 1** and **2** schematically show commonly used parameters specifying the geometry of a capillary 1, seen in cross sectional views of the capillary 1: Face Angle FA, Outer Radius OR, Hole Diameter H, Chamfer Diameter CD, Tip Diameter T, Inner Chamfer Angle ICA, Outer Diameter OD, Taper Angle (or Cone Angle) CA and Tool length TL

In the region of the tip of the capillary 1, the orientation or curvature of surface sections is defined by corresponding parameters. The surface sections shall be labelled - following the surface from the outside inwards - as follows:
- Outer Diameter surface, characterised by the outer diameter OD.
- Taper 11, characterised by the main taper angle MTA (alternatively, the terms chamfer surface and Cone Angle CA can be used). If the taper 11 has a bottleneck shape with subsections at different angles (Figure 3), it can be characterised by two corresponding taper angles, e.g. Main Taper Angle MTA and Bottleneck Angle BNA and a Bottleneck Height BNH. If the taper 11 has a stepped shape with corresponding subsections (**Figure 4**), it can be characterised by further parameters.
- Outer radius surface 12, characterised by the Outer Radius OR.
- Face surface 13, characterised by the Face Angle FA. The face surface 13 can also be called working surface.
- Inner chamfer surface 14, characterised by the Inner Chamfer Angle ICA. As shown in Figure 2, there can be more than one inner chamfer surfaces, adjacent to one another and with different characterising angles.
- Hole surface 15, characterised by the Hole Diameter H. The hole with the hole surface 15 can also be called wire feed aperture.

The terms "blank" and "capillary" are interchangeable to a certain extent, since the process of machining as described herein turns a blank into a capillary. So, a blank can be considered to be a capillary in unfinished form. Also, if reference is made to the capillary axis 19, this is the same as the axis or longitudinal axis of the blank 1, or at least parallel. So, if a laser beam 22 has a certain angle to the capillary axis 19, it has the same angle to the longitudinal axis of the blank 1, and if a plane is normal to the capillary axis 19, it is also normal to the longitudinal axis of the blank 1.

Generally, the sections and subsections are rotationally symmetric, and thus can be machined by rotating the blank 1 around its longitudinal axis, with a laser beam impinging tangentially on the blank 1.

In practice, it can be the case that the longitudinal axis of the blank 1 does not coincide with a central axis of a hole that is present in the blank 1. That is, the hole and the blank 1 are not concentric. In such cases it is possible to machine the blank so as to make the outer shape of the resulting capillary to be concentric with the hole. As a result, the capillary axis 19 of the final blank 1 is not coincident with the longitudinal axis of the original blank. This can be done by mechanically compensating for the eccentricity of the outer surface of the blank relative to the hole. It can also be done by measuring the eccentricity of the hole relative to the blank 1 and when machining the blank 1 controlling the laser beam 22 to compensate for the eccentricity of the hole by deflecting it synchronously with the rotation of the blank 1, machining the surfaces of the capillary to be concentric with the hole.

The following examples show the capillary axis 19 being coincident with the longitudinal axis of the blank 1 and the axis of rotation, and it is evident to the skilled person how to adapt the examples in case the axes are not coincident.

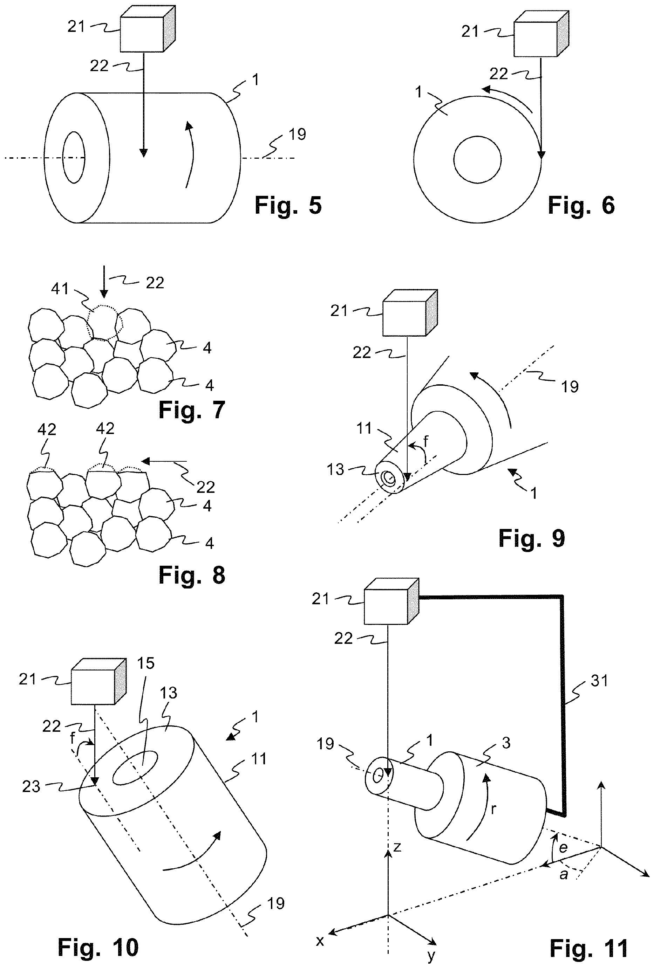

**Figures 5-6** show a tangentially impinging laser beam in a schematic perspective view and in a view in the direction of the capillary axis 19. The laser beam 22 is generated by a laser source 21 comprising, for example, a laser light generator, light guiding means, collimating and focusing optics, and deflection means for small scale deflection of the laser beam 22 in directions orthogonal to the direction of the beam.

The laser beam 22 is schematically indicated by an arrow, and it is understood that it is a focused beam, with the waist of the beam located at or near the point at which it impinges on a blank 1 being machined by means of laser ablation or sublimation with the laser beam 22. A direction of rotation of the blank 1 is indicated by an arrow. The direction of rotation usually is so that the surface moves against the direction of the laser beam 22 impinging on it.

**Figure 7** shows what happens when a laser beam fully impinges on a surface of a sintered material made up of grains 4 that are sintered to one another. The surface is generally horizontal in the drawing, and only a very small section is shown schematically. If the energy of the laser beam 22 hitting a grain 4 of the material within a certain time interval exceeds a certain limit, the energy absorbed by the grain 4 will cause it to evaporate or sublimate as a whole before the energy is dissipated to the other grains 3. This is indicated by a removed grain 41 shown outlined with dotted lines. The overall result of machining the surface in this way is that the roughness of the surface corresponds to the size of the grains 4 of the material. So, by tangentially hitting the surface and thus also the grains 4, only part of the grains 4 is removed, and the resulting overall surface has a finer, less rough structure.

**Figure 8** shows a laser beam 22 tangentially impinging on the surface. The laser beam 22 does not fully hit the surface, and part of it can pass by the surface altogether. An individual grain 4 does not receive the full energy of the beam, and thus is not evaporated or sublimated in its entirety. Rather, the energy suffices to evaporate or sublimate only part of one or more grains that are hit tangentially by the bean. This is indicated by removed parts 42 of grains shown outlined with dotted lines. The overall result of machining the surface in this way is that the roughness of the surface is smaller than with the laser beam fully impinging, as in **Figure 7****.**

**Figure 9** shows a laser beam tangentially impinging on a taper 11 of a blank for a capillary 1. Its longitudinal axis 19 lies at an angle f to the direction of the laser beam 22. This angle f is generally a **right angle.** Preferably it is larger than 45°, in particular larger than 60°, more in particular larger than 80°. The laser beam 22 oriented in this manner can be used to machine an outer periphery of the blank 1 with the laser beam 22 impinging tangentially. The surfaces machined in this way can be the taper 11, the outer radius surface 12 and the face surface 13.

Here and in the other examples, the direction of the laser beam 22 and the axis of the capillary 19 can constitute two skew lines. The angle f between these two skew lines is the angle between one of them and a straight line drawn parallel to the other through a point on the first line.

**Figure 10** shows a laser beam fully impinging on a face surface 13 of a blank for a capillary 1. Its longitudinal axis 19 lies at an angle f to the direction of the laser beam 22. This angle f is generally small, that is, the two directions are generally **parallel.** Preferably, the angle f is smaller than 45°, in particular smaller than 30°, more in particular smaller than 10°. The laser beam 22 oriented in this manner can be used to machine one or more faces of the blank with the laser beam fully impinging of these faces. The surfaces machined in this way can be the face surface 13 and the inner chamfer surface 14. It is also possible to machine the hole surface 15, in particular with the laser beam 22 being parallel to the axis of the hole surface 15 and the capillary axis 19. The laser beam 22 can be also oriented relative to the capillary axis 19 (or vice versa) for the laser beam 22 to impinge tangentially on the face surface 13, either with an offset from the capillary axis 19, as in **Figure 9****,** or intersecting the capillary axis 19.

**Figure 11** shows an apparatus for machining a blank. In addition to the laser source 21, laser beam 22 and blank or capillary 1 already described, it very schematically shows a fixture 3 holding the blank or capillary 1, and an articulated link 31 between the laser source 21 and the fixture 3. The articulated link 31 is a mechanical linkage between the two. It allows to move the two relative to one another, and it does not matter, in principle, how the two are moved relative to the environment. Typically the relative movement comprises rotating the fixture 3 around an axis of rotation and setting an angle between this axis of rotation and the direction of the laser beam 22. Typically, this axis of rotation coincides with a longitudinal axis of a blank 1 held in the articulated link 31. The angle of rotation is denoted as r in the figure, and the direction of the axis of rotation by e. In the example, e is an elevation angle over an X-Y-plane of a reference Euclidian coordinate system. The laser source 21 is oriented so that the laser beam 22 is essentially in the Z-direction of this coordinate system, normal to the X-Y-plane. The laser source 21 allows to deflect the laser beam 22 in the X and Y direction to a small degree, so that it can cover a working area comprising at least the width and length of the capillary 1 that needs to be machined. This can be several millimetres, e.g. up to 5 or 10 millimetres, measured at the distance from the laser source 21 at which the capillary 1 is arranged. With this arrangement it is possible to machine the capillary 1 in the manner described above by setting the elevation angle *e* to adjust the angle f between the capillary axis 19 and the direction of the laser beam 22 (while keeping the region of the capillary 1 being machined in the working area of the laser source 21). This can be done with the laser source 21 remaining fixed with regard to the environment, and rotating the fixture 3. Alternatively, the axis of rotation of the fixture 3 can remain fixed relative to the environment, and the laser source 21 can rotate around the working area (in which case the XYZ-coordinate system rotates with the laser source 21). In embodiments, the axis of rotation of the fixture 3 can also rotate around an azimuth angle *a* around the Z axis, in particular keeping the tip of the capillary 1 in the working region.

In embodiments, not illustrated, a measuring device such as a camera is arranged to capture an image along the axis of rotation of the fixture 3 and the blank 1. At least prior to machining the blank, the camera determines the position of the central hole in the capillary relative to the capillary 1 and/or the axis of rotation, that is, the eccentricity of the hole and the fixture 3. Instead of the camera, a one-dimensional sensor can be used, measuring the eccentricity while turning the blank around the axis of rotation of the fixture. When machining the blank, the laser beam 22 can be is continuously deflected to compensate for the eccentricity, depending on the angular position of the fixture 3 as it rotates.

While the invention has been described in present embodiments, it is distinctly understood that the invention is not limited thereto, but may be otherwise variously embodied and practised within the scope of the claims.

## Claims

1. A **method for machining a blank,** comprising the steps of
• providing a blank made of a sintered ceramic material;
• laser machining the blank with a laser beam (22) oriented to impinge **tangentially** on the surface of the blank,
• while **rotating** the blank (1) around an axis of rotation, the axis of rotation coinciding with or being parallel to a longitudinal axis (19) of the blank (1),
• thereby machining at least two surface sections of the blank,
o the at least two surface sections being rotationally symmetric with regard to the longitudinal axis, and
∘ the at least two surface sections being separated by a boundary curve, where a curve on the surface crossing the boundary curve has a stepwise change in curvature, and a **smooth change in the direction of a surface normal,**
∘ in particular wherein the boundary curve lies in a plane that is normal to the longitudinal axis.

2. The method of claim 1, comprising machining at least one surface of the blank (1) with the laser beam (22) oriented to **fully impinge on the surface,** in particular with an angle of more than 20° or more than 40° or more than 60° or more than 80° relative to the surface, and
in particular wherein the at least one surface is a surface that was **previously machined** with the laser beam oriented tangentially to the surface.

3. The method of claim 1 or claim 2, comprising **machining two or three or four or all surfaces of the blank without interruption,** in particular with one or more of the following being the case
• continuously operating the laser to generate a sequence of laser pulses between the machining of adjacent surfaces;
• holding the blank (1) in the same position in an end effector of the actuated fixture.

4. The method of one of the preceding claims, wherein the blank is a blank for a **wire bonding capillary** (1), in particular having an outer radius of less than three, in particular less than two millimetres.

5. The method of one of the preceding claims, comprising continuously rotating the blank 1 with a **speed of rotation** around the longitudinal axis of more than 200 RPM or more than 800 RPM or more than 1'000 RPM or more than 4'000 RPM or more than 10'000 RPM.

6. The method of one of the preceding claims, wherein the **laser pulses have a length** between 100 and 1000 femtoseconds, in particular between 200 and 800 femtoseconds, more in particular between 200 and 500 femtoseconds.

7. The method of one of the preceding claims, wherein the laser pulses have a **repetition frequency** between 10 kHz and 800 Mhz, in particular between 10 kHz and 10 MHz, more in particular between 50 kHz and 1 MHz.

8. The method of one of the preceding claims, wherein the laser pulses have a **wavelength** between 500 and 550 nanometres, in particular between 515 and 532 nanometres.

9. The method of one of the preceding claims, wherein the sequence of laser pulses has a **fluence** between 5 and 20 J/cm² , in particular with the wavelength of the pulses being between 515 and 532 nanometres.

10. The method of one of the preceding claims, wherein the **material of the blank** 1 is sintered Alumina, or sintered Zirconia or a sintered mixture of Alumina and Zirconia,
in particular wherein at least of one of the following is the case:
• the sintered material has a density of at least 96%,
• the material has a hardness of at least 1200 HV1.

11. The method of one of the preceding claims, wherein the material of the blank has a **grain size** of less than three micrometres, in particular less than (2) micrometres.

12. The method of one of the preceding claims depending on claim 4, comprising the step of machining the blank (1) by the steps of:
• orienting the longitudinal axis of the blank to be generally **at a right angle** to the direction of the laser beam (22) and machining an outer periphery of the blank (1) with the laser beam (22) **impinging tangentially** on the outer periphery of the blank,
∘ in particular wherein the outer periphery comprises one or more of a taper (11), an outer radius surface (12) and a face surface (13);
• orienting the longitudinal axis of the blank to be generally **parallel** to the direction of the laser beam (22) and machining one or more faces of the blank (1) with the laser beam (22) **fully impinging** of these faces,
o in particular wherein these faces are one or more of a face surface (13) and an inner chamfer surface (14).

13. The method of claim 12, with the step of orienting the longitudinal axis of the blank to be **parallel** to the direction of the laser beam (22) and machining at least one of the inner chamfer surface (14) and a hole surface (15) of the blank (1) with the laser beam (22) **impinging tangentially** on the hole surface (15).

14. The method of one of the preceding claims depending on claim 4, comprising, in order to align outer surfaces of the blank (1) with an existing hole or wire feed aperture present in the blank (1), by the steps of
• measuring a deviation of the hole with respect to the axis of rotation;
• when machining the blank (1), **compensating for the deviation of the hole** by deflecting the laser beam (22) depending on an angular position of the blank (1), in particular in a direction normal to the axis of rotation and normal to the direction of the laser beam (22).

15. **Apparatus for machining a blank,** configured to perform the method of one of the preceding claims, comprising
• a laser source (21) for generating a laser beam (22) for machining a blank (1) the laser source (21) being configured to deflect the laser beam (22) in directions orthogonal to the direction of the laser beam (22);
• a fixture (3) for holding and rotating the blank (1) around an axis of rotation, the axis of rotation coinciding with or being parallel to a longitudinal axis (19) of the blank (1),
• the laser source (21) and fixture (3) being arranged to be moveable relative to one another to set an angle between the longitudinal axis and the laser beam (22),
o in particular between a relative position in which they are generally normal and a relative position in which they are generally parallel.

16. **Wire bonding capillary,** manufactured by the method of one of the preceding claims 1 to 14, in particular with a smooth transition at a boundary curve between two sections at which, seen in a sectional plane comprising the axis of rotation, the surface of the capillary runs tangentially from one of the two sections into the other,
and in particular wherein one or more of the following is the case: the taper (11) and outer radius surface (12) run tangentially into one another, the outer radius surface (12) and face surface (13) run tangentially into one another, and the face surface (13) and inner chamfer surface (14) run tangentially into one another.
